# EUROPÄISCHE PATENTSCHRIFT

(11) **EP 0 599 319 B1**
(45) Veröffentlichungstag und Bekanntmachung des Hinweises auf die Patenterteilung: **20.09.1995**
(21) Anmeldenummer: 93119029.2
(22) Anmeldetag: 25.11.1993
(51) Int. Cl.: H05K 13/04, H05K 13/02

(54) **Vorrichtung zur Zuführung von aufgegurteten SMD-Bauteilen an Bestückautomaten**
Device for feeding belted SMD-components to mounting machines
Dispositif pour alimenter des automates de montage avec des composants SMD en bande

(30) Priorität: 26.11.1992 DE 9216116 U
(43) Veröffentlichungstag der Anmeldung: 01.06.1994
(73) Patentinhaber: SIEMENS AKTIENGESELLSCHAFT, 80333 München (DE)
(72) Erfinder: Schulze-Kahleyss, Rainer, D-91341 Röttenbach (DE); Hellerbrand, Christian, D-92421 Schwandorf (DE)

(56) Entgegenhaltungen:
- DE-A- 3 927 847
- DE-U- 8 525 978

## Beschreibung

Die Erfindung bezieht sich auf eine Vorrichtung zur Zuführung von SMD-Bauteilen an Bestückautomaten, wobei die Bauteile in Gurten magaziniert sind, die als parallele Rollen in einem Wagen od. dgl. zwecks Abrollen für die bestimmungsgemäße Verwendung geführt sind; (siehe z.B. DE-A-3 927 847).

Insbesondere SMD-Bauteile zur Bestückung von Leiterplatten werden häufig in Gurten magaziniert und auf Spulen aufgerollt. Jeweils mehrere Rollen mit unterschiedlichen Bauteilen sind dabei üblicherweise für die bestimmungsgemäße Verwendung parallel angeordnet. Dazu sind vom Stand der Technik beispielsweise Behälter mit steckbaren Trennblechen bekannt, die Schlitze aufweisen, in welche die Achsen der Spulen zwecks Abrollen gesteckt werden können. Alternativ dazu ist auch eine Lagerung der losen Rollen selbst bzw. der Gurtspulen am Außendurchmesser auf zwei Achsen innerhalb des Behälters möglich.

Nachteilig beim Stand der Technik ist die bisher unvermeidbare Reibung entweder an den Trennblechen und/oder an den Lagerachsen. Aufgabe der Erfindung ist es daher, eine verbesserte Vorrichtung zur Zuführung von in Gurtspulen magazinierten SMD-Bauteilen zu schaffen.

Die Aufgabe ist bei einer Vorrichtung der eingangs genannten Art dadurch gelöst, daß jede Rolle mit einer im Betriebszustand mit einem Tragelement festverbundenen Achse in diesem Tragelement geführt ist, das separat austauschbar ist, und daß jeweils eine Vielzahl von Tragelementen in Schlitzrastereinheiten nebeneinander angeordnet sind. Vorzugsweise sind die Tragelemente einzeln an einem Ende schwenkbar gelagert. Die Achsen können als separate Bolzen austauschbar sein. An einem Tragelement können eine Arbeitsspule und eine Vorratsspule hintereinander angeordnet sein.

Besonders vorteilhaft ist bei der Erfindung die Austauschbarkeit, insbesondere Schwenkbarkeit der Tragteile. Dadurch wird der Spulenwechsel erheblich einfacher als beim Stand der Technik.

Mit der Erfindung ergibt sich die Möglichkeit, entweder in an sich bekannter Weise einen separaten Wagen zu realisieren oder aber als Kassette zur Komplettierung vorhandener Einrichtungen, insb. sog. Wechselwagen, vorzusehen. Insbesondere kann aber nun eine solche Vorrichtung geschaffen werden, in der insgesamt eine Vielzahl von Einzelfunktionen integriert sind. In der Realisierung als Wagen kann ein solcher Multifunktionswagen als Beistellwagen sowohl links als auch rechts neben einem Bestückautomaten aufgestellt werden.

Weitere Einzelheiten und Vorteile der Erfindung ergeben sich aus der nachfolgenden Figurenbeschreibung von Ausführungsbeispielen.

Es zeigen
- FIG. 1: einen Längsschnitt und FIG. 2 einen Querschnitt einer als Wagen ausgebildeten erfindungsgemäßen Vorrichtung,
- FIG. 2: eine perspektivische Darstellung einer Vorrichtung mit Vorrüststation und
- FIG. 3: eine perspektivische Darstellung einer anderen Vorrichtung.

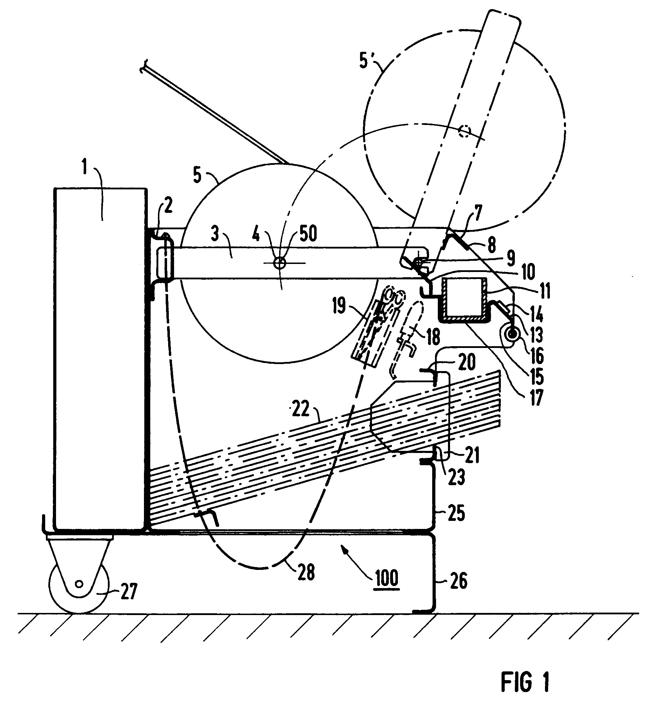

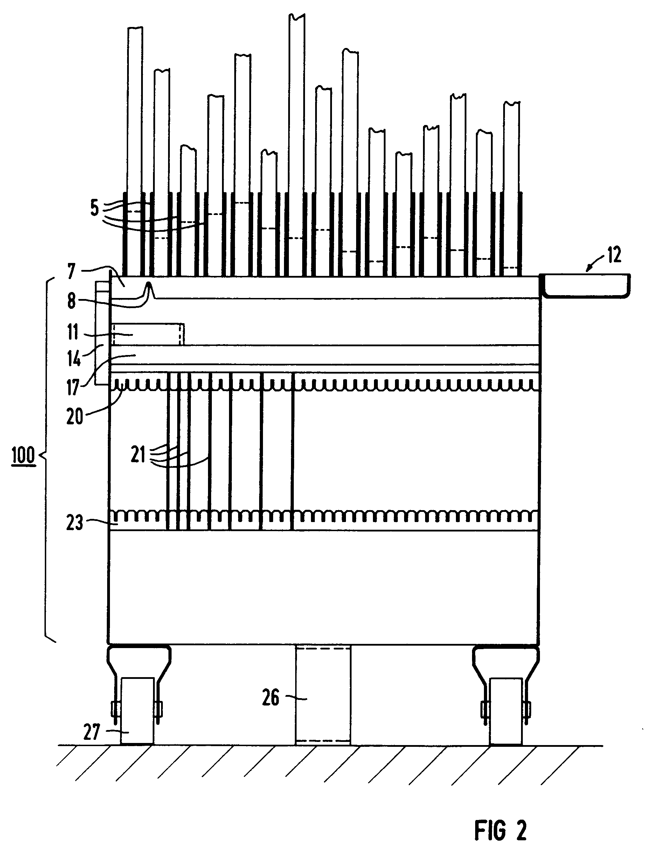

In der FIG. 1 ist mit 1 ein Behälter bezeichnet, der beispielsweise als Abfallbehälter dienen kann. Zusammen mit weiteren Blechformteilen, insbesondere einem Gehäuse 25, bildet der Behälter 1 die Basis für eine komplette Baueinheit 100, wobei das Gehäuse 25 eine hinreichende Stabilität gewährleistet. Am Gehäuse 25 ist in geeigneter Höhe ein Schlitzrasterblech 2 angebracht, das beispielsweise ein "16 mm-Raster" bildet. In das Schlitzrasterblech 2 können geeignete Flachteile 3 als Tragelemente eingeschoben werden, die an ihrer Rückseite schwenkbar gelagert sind und in Bohrungen 4 fest eingeschweißte Achsen 50 haben. Auf die Achsen 50 sind Spulen mit darauf aufgerollten Gurten schiebbar. Derartige Gurtrollen 5 können auf einer Achse 50 oder auf zwei Achsen 50 bzw. 50′ sitzend zum Abziehen der Gurte rotieren. Eine Mehrzahl nebeneinander angeordneter Gurtrollen 5 ist im einzelnen aus FIG. 2 ersichtlich.

Das Flachteil 3 ist als Spulenträgerblech ausgebildet und sitzt mit der Rückseite auf einer durchgehenden Achse 9 und einem Schlitzrasterwinkelblech 10. Es ist ein Anschlag vorhanden, der durch ein Winkelblech 7 mit einer Kerbe 8 gebildet wird, welche als Arbeitshilfe zum Entfernen von Verschlußnägeln od. dgl. dienen kann. Unter dem als Führungsteil 10 verlängerten Schlitzwinkelrasterblech ist ein Kunststoffbehälter 11 zur Aufnahme von Kerbnägeln od. dgl. angeordnet. Eine horizontale Blechschale 12 bildet eine Arbeitsfläche, die im einzelnen aus FIG. 2 erkennbar ist. Darunter ist ein Führungssteg 14 zur Aufnahme von Ringen 15 oder Anklemmen anderer Kennzeichnungsmittel 16 vorhanden. Eine Wanne 17 nimmt den Kunststoffbehälter 11, der insbesondere aus antistatischem EGB-Material besteht, auf.

An geeigneter Stelle der Vorrichtung sind ein Magnetstab 18 und eine Schere 19 als Hilfswerkzeuge vorhanden, worauf weiter unten noch im einzelnen eingegangen wird. Zwei Schlitzrasterwinkelschienen 20 und 23 sind in Querrichtung angeordnet, welche mit eingehängten Blechen 21 ein vorgegebenes Raster bilden können. Ein Gehäuseteil 25 und ein Standfuß 26 komplettieren die Basiseinheit 100 zu einer stabilen Vorrichtung. Weiterhin sind an der Arbeitsseite zwei Räder 27 als Laufrollen vorhanden, die die Flexibilität für einen wechselnden Einsatz der Vorrichtung gewährleisten.

Im einzelnen werden mit der vorstehend beschriebenen Vorrichtung folgende Einzelfunktionen erfüllt: Ein von einem einzigen Tragteil 3 gebildetes Spulenträgerblech, das mit der Achse 50 komplettiert ist, kann in die rückseitig durchlaufende Achse 9 eingehängt werden und wird durch das Schlitzrasterwinkelblech 10 seitlich geführt. Am anderen Ende erfolgt die seitliche Führung durch das Schlitzrasterblech 2. Bei Ausschwenken des Spulenträgerbleches 3 in die obere Position mit der gestrichelt angedeuteten Lage der Spule 5 kann ein Spulenwechsel vorgenommen werden. Da eine einzelne Spule 5 in einfacher Weise auf den Achsbolzen 50 im Tragteil 3 aufgesteckt ist, können alle Spulen leicht ausgetauscht werden. Nach einem Spulenwechsel wird das betreffende Spulenträgerblech 3 wieder in die Ausgangslage zurückgeschwenkt und der neue Gurt an den abgelaufenen Gurt angespliced.

Eine Vielzahl von Spulenträgerblechen 3 können in geeignetem Abstand des 16 mm-Rasters eingehängt werden. Bei breiteren Spulen für die zu Rollen aufgewickelten Magazingurte ist somit die Möglichkeit gegeben, zwei Tragelemente 3 mit einander zugewandten Achsen 50 bzw. 50′ einzusetzen, um von beiden Seiten in die Spulennabe einzugreifen. Die Schlitze haben zur leichteren Kennung jeweils alle 32 mm eine runde Markierung im Schlitzrasterblech 2.

Der Abfallbehälter 1 kann seitlich herausgezogen werden und dient beispielsweise zur Aufnahme von Gurtabfällen. Solche Abfälle können beispielsweise direkt aus der Maschine in den Abfallbehälter 1 geleitet werden. Weiterhin sind darin leere Stangenmagazine für Bauelemente ablegbar. Zum Entfernen von Verschlußnägeln aus Stangenmagazinen ist insbesondere eine Kerbe 8 vorgesehen. Dadurch kann durch Einstecken und Anhebeln eines Stangenmagazines der Veschlußnagel ohne zusätzliche Hilfswerkzeuge entfernt werden und fällt unmittelbar in den Behälter 11 aus EGB-Kunststoffmaterial. Seitlich ist zur Ablage von Werkzeugen und anderer Hilfsmittel, wie beispielsweise eines Klebeband-Spendeautomaten, die Wanne 12 in geeigneter Position vorgesehen. Insbesondere zum Gurtansplicen steht somit eine geeignete Abseits- und Aufnahmefläche zur Verfügung.

Die Aufnahmewanne 17 für den EGB-Behälter 11 kann ebenfalls auch zur Ablage von Werkzeugen dienen. Die abgeschrägte Fläche des vorderen Wannenteiles 17 ist mit einem magnetischen Selbstklebestreifen beklebt, um darauf eine Blechschiene 13 zu befestigen, auf der auftragsbezogene Spurkennungen aufgebracht werden können: Beispielsweise sind farbige Kunststoffringe 16 spurgenau am Blech 17 anklemmbar und dienen insbesondere zum Codieren von Spurfehlern, die auf der Schiene 13 ablesbar sind. Die Schere 19 ist seitlich griffbereit und mittels eines Kunststoffteils 28 unverlierbar befestigt. Der Magnetstab 18, mit dem sich aus dem Gurt gelöste Bauteile bei stillstehender Maschinen aus schwer zugänglichen Stellen der Maschine entfernt werden können, ist seitlich daneben angebracht.

Die Schlitzrasterwinkelbleche 20 und 23 haben Schlitze speziell im 5 mm-Raster und sind zur besseren Orientierung alle 30 mm mit einer zusätzlichen Lochkennung im Schlitz versehen. Sie dienen zur Aufnahme von variabel einhängbaren Trennwandblechen 21. In den dadurch im unteren Gehäuseteil 25 entstehenden Fächern können spurgenau volle Stangenmagazine aufbewahrt werden.

Die Vorrichtung hat einen Standfuß 26 und ist gemäß FIG. 1 und FIG. 2 mittels zweier gegenüberliegender Räder 27 fahrbar ausgebildet. Wenn der Standfuß 26, die Räder 27 und der Abfallbehälter 1 entfernt sind, kann die mit dem Gehäuse 25 verbleibende Kassette als Basiseinheit 100 in bereits vorhandene Wechselwagen eingebaut werden. Dazu können Montagemittel vorhanden sein, mit denen die gesamte Basiseinheit 100 seitlich gefaßt und angehoben werden kann. In der Realisierung als Wechselwagen ist ein Anschieben bei einer Fortbewegung über die Laufräder 27 über das als Transportgriff ausgebildete Blech 17 möglich.

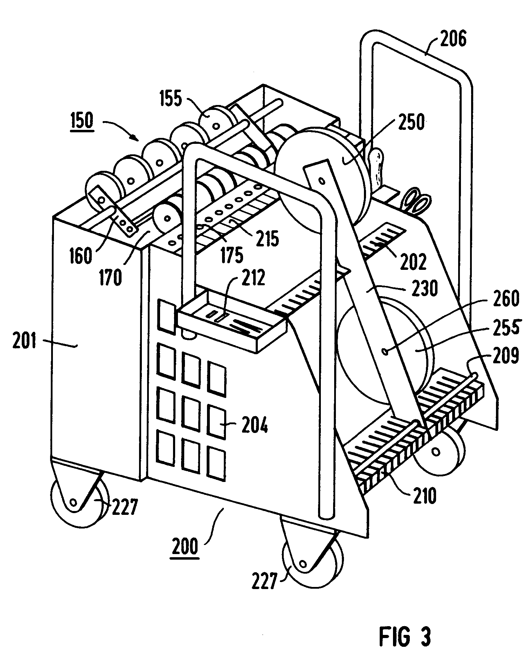

In Figur 3 definiert die Position 200 die Basiseinheit eines Gurtwagens, dem in diesem Fall eine Vorrüststation vorgeschaltet ist. Im einzelnen sind die meisten Funktionseinheiten des Gurtwagens entsprechend Figur 1 und Figur 2 aufgebaut, was aus der perspektivischen Darstellung im einzelnen erkennbar ist:

Zwei gegenüberliegende Schlitzrasterbleche 202 und 210 mit "16 mm Kammraster" werden von zwei Seitenwänden 205 begrenzt, an die jeweils Transportgriffe 206 angebracht sind. Die Kammbleche 202 und 210 dienen zur Aufnahme von ausschwenkbaren Spulenträgern 230 mit Spulen 250 und 255. Im unteren Kammblech 210 ist eine Rundstange 209 geführt, in die die Spulenträger 130 einhängbar sind, wobei sie um die Achse der Rundstange schwenkbar sind.

Der Spulenträger hat in Figur 3 zwei Bohrungen 134 und 135, in die Gurtspulen 250 und 255 einsteckbar sind. Hierzu sind jeweils wiederum Drehachsen 260 vorhanden, die als Bolzen verschiedener Länge austauschbar ausgebildet sein können. Es ergibt sich somit die Möglichkeit, die erste Spule 250 als Arbeitsspule und die zweite Spule 255 als Vorratsspule zu verwenden. Dabei können aufgrund der günstigen Raumanordnung Spulen mit 38 mm Durchmesser verwendet werden.

Der Basiseinheit 200 ist wie in Figur 1 ein Abfallbehälter 201 vorgeschaltet. Die gesamte Basiseinheit ist auf Rollen 227 verschiebbar gelagert.

Über dem Abfallbehälter 201 ist eine demontierbare Umrüsteinrichtung 150 angebracht. Diese besteht im einzelnen aus den bekannten Abzugsspulen, die in die eigentliche Bestückmaschine übernommen werden, wobei weiterhin eine Transportsicherung für die Fördereinrichtung und die Abzugsspulen vorhanden ist.

In Figur 3 sind in die Seitenwände 203 Aussparungen 204 eingebracht, in die quer zur Vorrichtung IC-Magazine eingeschoben werden können. Die Hilfsmittel zur Aufnahme von Werkzeugen, wie Pinzette, Klebestreifen, Schere und Magnetstab, entsprechen im wesentlichen der Figur 1. Zusätzlich sind hier in der Umrüsteinrichtung 150 Mittel 160 zur Spurbeschriftung sowie Bohrungen 165 für Stecker oder dergleichen vorhanden.

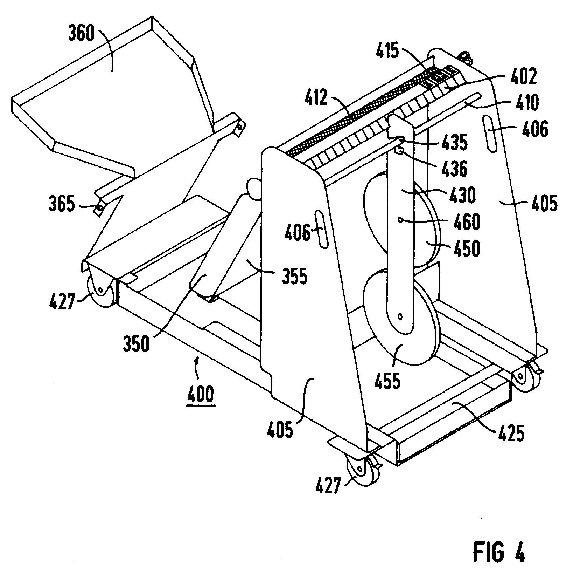

In Figur 4 wird eine Basiseinheit 400 von zwei Seitenblechen 405 mit Transportgriffen 406 begrenzt, zwischen denen in vorgegebener Höhe ein Kammblech 402 mit "15 mm Raster" angeordnet ist, dem eine Rundstange 410 parallelgeschaltet ist. Die Rundstange dient zur Aufnahme von Spulenträgern 430 in vorgegebenem Raster, wobei die Spulenträger im Normalfall in einer Ausnehmung 430 gelagert sind und eine Raste 436 zum Höherstellen vorhanden ist. Der Spulenträger weist zwei Bohrungen 434 im Abstand auf, in welche Gurtspulen 450 bzw. 455 mit Achsen einhängbar sind. Die Achsen können wiederum unterschiedliche Länge aufweisen und austauschbar sein. Mit dieser Ausbildung sind die Spulenträger 430 zum Bestücken bzw. austauschbar ausschwenkbar bzw. ganz herausnehmbar.

Unterhalb des Kammbleches 402 ist durchgehend eine Ablagewanne 411 zwischen den beiden Endblechen 406 vorhanden, die zur Aufnahme von Pinzette, Klebestreifen, Abzugsspulen und anderen Hilfsmitteln dient. Die freie Oberfläche des Kammbleches 402 kann zur Aufnahme von Beschriftungen für die einzelnen Spuren verwendet werden. Insbesondere kann dafür ein sogenannter Barcode benutzt werden.

Maschinenseitig sind sogenannte Feeder 350 vorhanden, die auf Auflageblechen 355 liegen. Diese nehmen wiederum Abziehspulen für die eigentliche Bestückeinrichtung auf. Weiterhin ist für den bestimmungsgemäßen Gebrauch bei einer Bestückeinrichtung eine Gurtrutsche 360 vorhanden, die schwenkbar ausgebildet ist, so daß Abfallteile in jedem Fall gesammelt werden und nicht den Umgebungsraum verunreinigen. Hierzu ist am Boden der Basiseinheit 400 mit Rollen 427 eine Schublade 425 eingebracht, in der Abfälle gesammelt und durch Herausziehen in einfacher Weise entsorgt werden können.

Bei den allen vorstehend beschriebenen Vorrichtungen ist gegenüber dem Stand der Technik die Reibung der Spulen durch die beispielsweise nur 60 mm breiten Spulenträgerbleche 3 und weiterhin durch die Aufnahme der Rollen mit unterschiedlichem Anbaudurchmesser in der Spulennabe wesentlich reduziert. Da keine Umlenkbleche für die Gurte notwendig sind, entfallen weitere Reibungsflächen, die bisher häufig Maschinenstörungen verursachten.

Über die in den Figuren im einzelnen dargestellten Merkmale ergibt sich die Möglichkeit, weitere für die Praxis notwendige Funktionen in die Vorrichtung zu integrieren. Insgesamt lassen sich damit beachtliche Verbesserungen für den Fertigungsbetrieb erreichen.

## Patentansprüche

1. Vorrichtung zur Zuführung von SMD-Bauteilen an Bestückautomaten, wobei die Bauteile in Gurten magaziniert sind, die als parallele Rollen in einem Wagen od. dgl. zwecks Abrollen für die bestimmungsgemäße Verwendung geführt sind, **dadurch gekennzeichnet,**
daß jede Rolle (5, 250, 255, 450, 455) mit einer im Betriebszustand mit einem Tragelement fest verbundenen Achse (50, 260, 460) in diesem Tragelement (3, 230, 430) geführt ist, das separat austauschbar ist, und daß jeweils eine Vielzahl von Tragelementen (3, 230, 430) in Schlitzrastereinheiten (2, 10, 202, 210; 402, 450) nebeneinander angeordnet sind.

2. Vorrichtung nach Anspruch 1, **dadurch gekennzeichnet,** daß die Tragelemente (3, 230, 430) an einem Ende schwenkbar gelagert sind.

3. Vorrichtung nach Anspruch 1, **dadurch gekennzeichnet,** daß an einem Tragelement (230, 430) eine Arbeitsspule und eine Vorratsspule (255, 455) untereinander anordenbar sind.

4. Vorrichtung nach Anspruch 1, **dadurch gekennzeichnet,** daß die im Betriebszustand mit der Gurtrolle (5, 250, 255, 450, 455) fest verbundene Achse (50) austauschbar ist.

5. Vorrichtung nach Anspruch 1, **dadurch gekennzeichnet,** daß mit den Tragelementen (3, 230, 430) in den Schlitzrastereinheiten (2, 10, 202, 210, 402, 410) ein 16 mm-Raster gebildet wird.

6. Vorrichtung nach Anspruch 1, **dadurch gekennzeichnet,** daß eine kastenförmige Basiseinheit (100, 200) gebildet ist, die zwischen gegenüberliegenden Begrenzungen zwei einzelne Schlitzrastereinheiten (2, 10, 202, 210) zum Einhängen der Tragelemente (3, 230) aufweist.

7. Vorrichtung nach Anspruch 6, **dadurch gekennzeichnet,** daß die Basiseinheit (100, 200, 400) einen integrierten Abfallbehälter (1, 210, 401) für Gurtreste und Stangenmagazinreste beinhaltet.

8. Vorrichtung nach Anspruch 6, **dadurch gekennzeichnet,** daß die Basiseinheit (100, 200, 400) einen integrierten Scherenhalter (19, 28) aufweist.

9. Vorrichtung nach Anspruch 6, **dadurch gekennzeichnet,** daß die Basiseinheit (100, 200, 400) einen integrierten Magnetstabhalter (18) beinhaltet.

10. Vorrichtung nach Anspruch 6, **dadurch gekennzeichnet,** daß an der Basiseinheit (100, 200, 400) eine Schiene (13, 213, 413) mit Kennungsmitteln (14, 214, 414) zur auftragsbezogenen Spurerkennung angebracht ist.

11. Vorrichtung nach Anspruch 10, **dadurch gekennzeichnet,** daß die Kennungsmittel ein Magnetstreifen und/oder ein sog. Barcode sind.

12. Vorrichtung nach Anspruch 6, **dadurch gekennzeichnet,** daß in die Basiseinheit (100, 200, 400) variable Vorratskammern für die auftragsbezogene Ablage von Stangenmagazinen (22) integriert sind.

13. Vorrichtung nach Anspruch 6, **dadurch gekennzeichnet,** daß in die Basiseinheit (100, 200, 400) eine Ablagewanne (17, 217, 417) für Hilfswerkzeuge integriert ist.

14. Vorrichtung nach Anspruch 6, **dadurch gekennzeichnet,** daß an die Basiseinheit (100) eine seitliche Auflage (12) zum Gurtansplicen angebracht ist.

15. Vorrichtung nach Anspruch 5, **dadurch gekennzeichnet,** daß zur Markierung von Spurfehlern farbige Kennungsringe (16) vorhanden sind.

16. Vorrichtung nach Anspruch 6, **dadurch gekennzeichnet,** daß die Basiseinheit (100, 200, 400) wenigstens einen Transportgriff (206, 406) hat.

17. Vorrichtung nach Anspruch 6, **dadurch gekennzeichnet,** daß die Basiseinheit (100) eine Austauschkassette für einen vorhandenen Wechselwagen bildet.

18. Vorrichtung nach Anspruch 6, **dadurch gekennzeichnet,** daß die Basiseinheit (100) mit einem Fußteil (26) und zwei gegenüber angeordneten Rädern (27) einen eigenen Vorrüstwagen bildet.

19. Vorrichtung nach Anspruch 18, **dadurch gekennzeichnet,** daß der Basiseinheit eine Vorrüsteinheit (150) als Austauschmodul zugeordnet ist.

## Claims

1. Device for feeding SMD components to mounting machines, the components being loaded in a cassette in belts which are guided as parallel rolls in a carriage or the like for the purpose of unwinding for the specific use, characterized in that each roll (5, 250, 255, 450, 455) is guided in a carrier element (3, 230, 430) using a pivot (50, 260, 460) which is firmly connected to the former in the operating condition, the carrier element being separately interchangeable, and in that in each case a multiplicity of carrier elements (3, 230, 430) are arranged beside one another in slotted grid units (2, 10, 202, 210; 402, 450).

2. Device according to Claim 1, characterized in that the carrier elements (3, 230, 430) are supported pivotably at one end.

3. Device according to Claim 1, characterized in that a working coil and a supply coil (255, 455) can be arranged one below the other on a carrier element (230, 430).

4. Device according to Claim 1, characterized in that the pivot (50) which is firmly connected to the belt roll (5, 250, 255, 450, 455) in the operating condition is interchangeable.

5. Device according to Claim 1, characterized in that, using the carrier elements (3, 230, 430) in the slotted grid units (2, 10, 202, 210, 402, 410), a 16 mm grid is formed.

6. Device according to Claim 1, characterized in that a box-shaped base unit (100, 200) is formed which has, between opposite boundaries, two individual slotted grid units (2, 10, 202, 210) for hanging the carrier elements (3, 230).

7. Device according to Claim 6, characterized in that the base unit (100, 200, 400) includes an integrated waste container (1, 201, 401) for belt residues and bar-magazine residues.

8. Device according to Claim 6, characterized in that the base unit (100, 200, 400) has an integrated scissors holder (19, 28).

9. Device according to Claim 6, characterized in that the base unit (100, 200, 400) contains an integrated magnetic-rod holder (18).

10. Device according to Claim 6, characterized in that a rail (13, 213, 413) having identification means (14, 214, 414) for job-related track detection is fitted on the base unit (100, 200, 400).

11. Device according to Claim 10, characterized in that the identification means are a magnetic strip and/or a so-called bar code.

12. Device according to Claim 6, characterized in that variable supply chambers for the job-related deposit of bar magazines (22) are integrated into the base unit (100, 200, 400).

13. Device according to Claim 6, characterized in that a deposit trough (17, 217, 417) for auxiliary tools is integrated into the base unit (100, 200, 400).

14. Device according to Claim 6, characterized in that a lateral support (12) for splicing on belts is fitted onto the base unit (100).

15. Device according to Claim 5, characterized in that there are coloured identification rings (16) for marking track errors.

16. Device according to Claim 6, characterized in that the base unit (100, 200, 400) has at least one transport handle (206, 406).

17. Device according to Claim 6, characterized in that the base unit (100) forms an interchangeable cassette for an existing change carriage.

18. Device according to Claim 6, characterized in that the base unit (100) forms, with a foot part (26) and two wheels (27) arranged opposite, a self-contained pre-equipment carriage.

19. Device according to Claim 18, characterized in that the base unit is assigned a pre-equipment unit (150) as interchangeable module.

## Revendications

1. Dispositif pour amener des composants SMD jusqu'à des automates d'équipement, les composants étant logés dans des courroies qui sont guidées sous la forme de rouleaux parallèles dans un chariot ou analogue pour être déroulées pour l'utilisation conforme aux spécifications, caractérisé par le fait que chaque rouleau (5,250,255,450, 455) comportant un axe (50,260,460), relié de façon fixe à un élément de support dans l'état de fonctionnement, est guidé dans cet élément de support (3,230,430), qui peut être remplacé séparément, et que respectivement une multiplicité d'éléments de support (3,230,430) sont disposés côte-à-côte dans des unités à réseau de fentes (2,10,202,210;402,450).

2. Dispositif suivant la revendication 1, caractérisé par le fait que les éléments de support (3,230, 430) sont montés de manière à pouvoir basculer à une extrémité.

3. Dispositif suivant la revendication 1, caractérisé par le fait qu'une bobine de travail et une bobine débitrice (255,455) peuvent être disposées l'une au-dessous de l'autre sur un élément de support (230,430).

4. Dispositif suivant la revendication 1, caractérisé par le fait que l'axe (50), qui est relié de façon fixe, dans l'état de fonctionnement, au rouleau de la courroie (5,250,255,450,455), est remplaçable.

5. Dispositif suivant la revendication 1, caractérisé par le fait qu'une trame de 16 mm est formée avec les éléments de support (3,230,430) dans les unités à réseau de fentes (2,10,202,210,402,410).

6. Dispositif suivant la revendication 1, caractérisé par le fait qu'une unité de base en forme de boîte (100,200) est formée, cette unité possédant, entre des limites opposées, deux unités individuelles à réseau de fentes (2,10,202,210) pour l'accrochage des éléments de support (3,230).

7. Dispositif suivant la revendication 6, caractérisé par le fait que l'unité de base (100,200,400) comporte un récipient intégré à déchets (1,210,401) pour des restes de courroie et des restes de magasins à barres.

8. Dispositif suivant la revendication 6, caractérisé par le fait que l'unité de base (100,200,400) comporte un porte-cisaille intégré (19,28).

9. Dispositif suivant la revendication 6, caractérisé par le fait que l'unité de base (100,200,400) comporte un support intégré de barreau aimanté (18).

10. Dispositif suivant la revendication 6, caractérisé par le fait que sur l'unité de base (100,200,400) est monté un rail (13,213,413) comportant des moyens d'identification (14,214,414) servant à identifier une piste, en rapport avec une commande.

11. Dispositif suivant la revendication 10, caractérisé par le fait que les moyens de caractérisation sont une bande magnétique et/ou ce qu'on appelle un code à barres.

12. Dispositif suivant la revendication 6, caractérisé par le fait que des chambres variables sont intégrées, dans l'unité de base (100,200,400), pour le rangement, rapporté à une commande, de magasins à barres (22).

13. Dispositif suivant la revendication 6, caractérisé par le fait qu'une cuvette de rangement (17,217, 417) pour des outils auxiliaires est intégrée dans l'unité de base (100,200,400).

14. Dispositif suivant la revendication 6, caractérisé par le fait qu'un support latéral (12) pour des épissures de courroie est disposé sur l'unité de base (100).

15. Dispositif suivant la revendication 5, caractérisé par le fait que des anneaux d'identification colorés (16) sont présents pour le marquage d'erreurs de traces.

16. Dispositif suivant la revendication 6, caractérisé par le fait qu'une unité de base (100,200,400) possède au moins une poignée de transport (206,406).

17. Dispositif suivant la revendication 6, caractérisé par le fait que l'unité de base (100) forme une cassette interchangeable pour un chariot changeur existant.

18. Dispositif suivant la revendication 6, caractérisé par le fait que l'unité de base (100) pourvue d'une partie formant pied (26) et de deux roues (27) disposées en vis-à-vis, forme un chariot proprement dit d'équipement préalable.

19. Dispositif suivant la revendication 18, caractérisé par le fait qu'à l'unité de base est associée une unité d'équipement préalable (150) en tant que module interchangeable.
